Europäisches Patentamt

European Patent Office

Office européen des brevets

(19)

(11) Publication number: **0 143 662**
**B1**

(12) # EUROPEAN PATENT SPECIFICATION

(45) Date of publication of patent specification: **22.03.89**

(21) Application number: **84308280.1**

(22) Date of filing: **29.11.84**

(51) Int. Cl.⁴: **H 01 L 21/74, H 01 L 21/86,**
**H 01 L 21/20**

(54) Soi type semiconductor device.

(30) Priority: **30.11.83 JP 225654/83**
**30.11.83 JP 225657/83**

(43) Date of publication of application:
**05.06.85 Bulletin 85/23**

(45) Publication of the grant of the patent:
**22.03.89 Bulletin 89/12**

(84) Designated Contracting States:
**DE FR GB**

(56) References cited:
**FR-A-2 517 123**
**US-A-3 433 686**
**US-A-4 224 636**
**US-A-4 393 572**
**IBM TECHNICAL DISCLOSURE BULLETIN, vol.
24, no. 11A, April 1982, pages 5458-5459, New
York, US; M.D. HULVEY et al.: "Dielectric
isolation process"**
**IBM TECHNICAL DISCLOSURE BULLETIN, vol.
25, no. 11A, April 1983, pages 5670-5671, New
York, US; D.G. CHESEBRO et al.: "Bipolar
dynamic random-access memory cell"**

(73) Proprietor: **FUJITSU LIMITED**
**1015, Kamikodanaka Nakahara-ku
Kawasaki-shi Kanagawa 211 (JP)**

(72) Inventor: **Kanbara, Kazuhiro c/o Fujitsu Limited,
Patent Dep.
1015 Kamikodanaka, Nakahara-ku
Kawasaki-shi Kanagawa, 211 (JP)**
Inventor: **Hataishi, Osamu c/o Fujitsu Limited
Patent Dep. 1015 Kamokodanaka Nakahara-ku
Kawasaki-shi Kanagawa, 211 (JP)**

(74) Representative: **Sunderland, James Harry et al
HASELTINE LAKE & CO Hazlitt House 28
Southampton Buildings Chancery Lane
London WC2A 1AT (GB)**

(56) References cited:
**IBM TECHNICAL DISCLOSURE BULLETIN, vol.
8, no. 9, February 1966, pages 1296-1297, New
York, US; V.Y. DOO et al.: "Making contacts to
buried subcollectors in integrated circuit
devices"**
**RCA REVIEW, vol. 44, no. 2, June 1983, pages
250-269, Princeton, N.J., US; L. JASTRZEBSKI
et al.: "Comparison of SOI technologies"**

**EP 0 143 662 B1**

(56) References cited:
J. ELECTROCHEM. SOC.: SOLID-STATE
SCIENCE AND TECHNOLOGY, vol. 130, no. 11,
November 1983, pages 2271-2274; K.
TAKEBAYASHI et al.: "Infrared radiation
annealing of ion-implanted polycrystalline
silicon using a graphite heater"

## Description

The present invention relates to an SOI (Semiconductor on Insulator) type semiconductor device.

SOI technology, in which a number of semiconductor single crystalline layers, having widths and lengths of an order from a few tens to hundreds of micrometers for example, are formed on an insulating layer and then a functional device such as a transistor or a diode is fabricated in each of the single crystalline layers, is a possible source of a breakthrough with regard to speed and packing density limitations of future LSI (large scale integration) circuits. That is, since each semiconductor single crystalline layer is usually formed so as to be embedded in an insulating matrix having a depth of a few tenths of a micron, a transistor or diode fabricated in the single crystalline layer is dielectrically isolated from others and also from the substrate, which is for example of silicon, and therefore can be of low stray capacity and high breakdown voltage characteristics.

The single crystalline layers may be formed by recrystallizing a polycrystalline layer, such as a polysilicon layer, which has a thickness on the order of micrometers, and is deposited on an insulating layer such as silicon dioxide. The polycrystalline layer is passivated except in regions at which final single crystalline layers are formed. These regions are referred to as device regions hereinafter. There are various possibilities for performing the passivation prior to or after the recrystallization, and for performing the recrystallization with regard to the entirety of or parts of the polycrystalline layer. Thus, islands of single crystalline layers floating in an insulating matrix are obtained. An epitaxial layer is then formed on each recrystallized layer by using an ordinary epitaxial growth technique such as CVD (Chemical Vapor Deposition), if necessary.

Structured as explained above, an SOI type semiconductor device can be referred to also as a dielectric isolated integrated circuit. If the insulating layer and single crystalline layers thereon are formed on a substrate wherein transistors or diodes have been fabricated in advance, a three-dimensional integrated circuit is possible. The three-dimensional structure can be extended further, if a further insulating layer and further semiconductor single crystalline layers are stacked on the insulating layer and the single crystalline layers already formed.

Some preliminary reparts with regard to the fabrication of semiconductor single crystalline layers and prototype SOI semiconductor devices, including three-dimensional integrated circuits, have been issued, for example "Recrystallization of Si on amorphous substrates by doughnut-shaped cw Ar laser beam" by S. Kawamura et al., Appl. Phys. Lett. 40(5), 1 March 1982, and "Three-dimensional CMOS IC's Fabricated by Using Beam Recrystallization" by S. Kawamura et al., IEEE ED Letters, vol. EDL-4, No. 10, Oct. 1983.

In the applicant company it has been realized that, as in ordinary bipolar integrated circuits directly formed on a silicon substrate, a highly doped buried layer (for reducing collector resistivity) may be an advantageous provision for a transistor in a SOI type semiconductor device based on the bipolar technology. To date it seems there has been no disclosure concerning the fabrication of a buried layer of an SOI type semiconductor device. Previously discussed SOI type bipolar semiconductor devices have been mainly based on so-called lateral bipolar technology (for example, "Fully Isolated Lateral Bipolar-MOS Transistors Fabricated in Zone-Melting-Recrystallized Si films on SiO$_2$" by B-Y. Tsaur et al., IEEE ED Letters, vol. EDL-4, No. 8, Aug. 1983), wherein the resistivity of collector region is not a serious problem.

In the applicant company it has been proposed that a buried layer be formed in the original single crystalline layer as recrystallized, and a functional device such as transistor be fabricated in an epitaxial layer grown on the recrystallized layer.

According to the present invention there is provided a method for fabricating an SOI (Semiconductor on Insulator) type semiconductor device, comprising:

forming a single crystalline island on an insulating layer formed on a substrate, said single crystalline island having one conductivity type;

forming an epitaxial layer on said single crystalline island;

forming a tentative exposed side surface of said epitaxial layer;

forming a conduction path at said exposed side surface, said conduction path extending from the upper surface of said epitaxial layer to said single crystalline island thereunder.

An embodiment of the present invention can provide a method for forming a connection to a buried layer of a semiconductor device fabricated by using SOI technology.

An embodiment of the present invention can provide an SOI type semiconductor device comprising a bipolar transistor equipped with a buried layer.

. An embodiment of the present invention can provide for the formation of connection to the buried layer of a bipolar transistor of such an SOI type semiconductor device.

A method of fabricating an SOI type semiconductor device according to an embodiment of the present invention comprises:

forming a single crystalline island on an insulating layer formed on a substrate, the single crystalline island being provided with one conductivity type and being used as a buried layer in the finished device;

forming an epitaxial layer on the single crystalline island;

forming tentative exposed side surface(s) of the epitaxial layer; and

forming a conduction path on the exposed side surface(s), the conduction path extending from the upper surface of the epitaxial layer to the single crystalline island thereunder.

One way of forming the tentative exposed side surface(s) of the epitaxial layer is to remove a polycrystalline layer formed around the epitaxial layer during the process of epitaxial growth, and another way is to provide the epitaxial layer with a groove at its peripheral area. One way of forming the conduction path on the tentative exposed side surface(s) is to dope the side surface(s) with impurities of the same conductivity type as that of the buried layer, and another way is to fill the groove with a polycrystalline material doped with such impurities.

Reference is made, by way of example, to the accompanying drawings, in which:-

Figs. 1(a) to 1(k) are respective schematic cross-sectional views illustrating an embodiment of the present invention,

Figs. 2(a) to 2(g) are respective schematic cross-sectional views illustrating another embodiment of the present invention, and

Figs. 3(a) and 3(b) are schematic enlarged cross-sectional and plan views, respectively, of an SOI type semiconductor device fabricated according to an embodiment of the present invention.

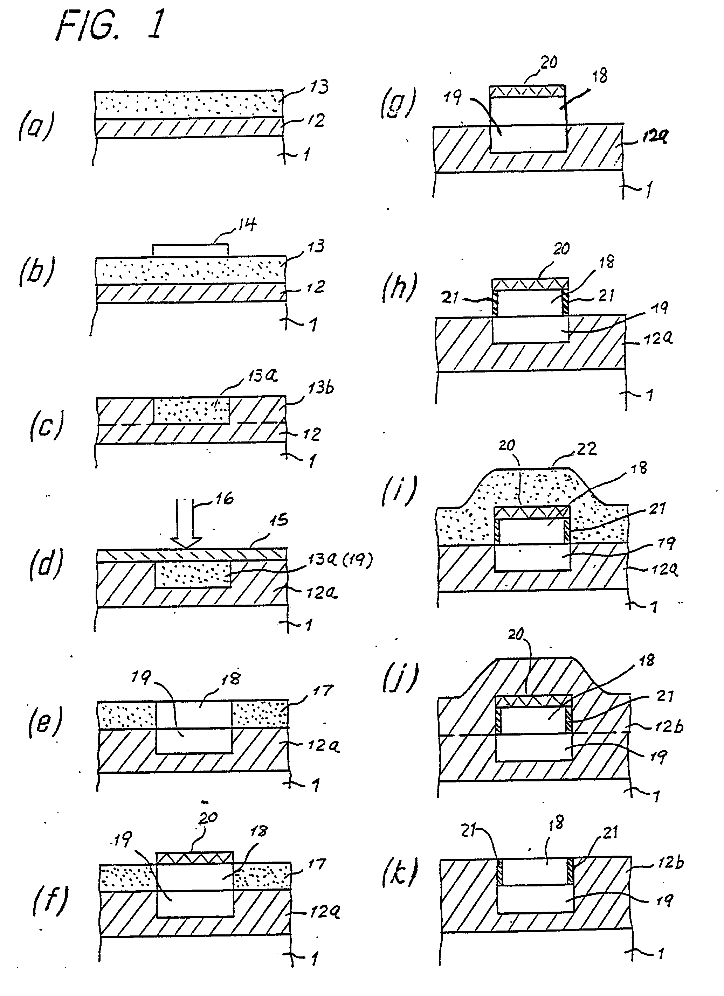

The schematic cross-sectional views of Figs. 1(a) to 1(k) illustrate stages in the manufacture of an SOI type semiconductor device according to an embodiment of the present invention.

In the following description of embodiments of this invention, essential parts of the SOI type semiconductor devices are described as being formed from silicon or polysilicon, in order to make the description more definite. However, embodiments of the present invention can be provided which use other materials.

As a first step, a polysilicon layer 13, for example, having a thickness of about 2 micrometers is deposited on the surface of an insulating layer 12 which is formed on a substrate 1, as shown in Fig. 1(a). The substrate 1 is a silicon wafer, for example, or a GaAs wafer or a vitreous substrate such as fused silica. An exemplary method for forming the polysilicon layer 13 is a CVD (Chemical Vapour Deposition) method. The insulating layer 12 may be a silicon dioxide ($SiO_2$) layer formed by oxidation of the substrate 1 if the substrate is composed of silicon, or may be an aluminium oxide ($Al_2O_3$) layer deposited on the substrate 1 by using conventional thin film technology. The thickness of the insulating layer is 0.5 micrometers, for example.

Next, the surface of the polysilicon layer 13 is selectively masked by a layer 14, a silicon nitride ($Si_3N_4$) layer, for example. The selective masking is performed firstly by depositing the layer 14 on the entire surface of the polysilicon layer 13, then patterning the layer 14 so that only a predetermined portion (device region) of the polysilicon layer 13 is masked by the layer 14, as shown in Fig. 1(b). The device region has dimensions of 8 micrometers width and 20 micrometers length, for example.

Following the above, the exposed portion of the polysilicon layer 13 is passivated by using a conventional thermal oxidation process, for example, and then the masking layer 14 is removed, as shown in Fig. 1(c). That portion 13a of the previous polysilicon layer 13, which is prevented from being passivated by virtue of the presence of the masking layer 14, remains as polysilicon. Since the removal of the masking layer 14 is usually carried out by using a chemical process, the masking layer 14 should be formed from a material such as $Si_3N_4$ which can more easily be removed by a chemical reagent than the passivated polysilicon layer 13b (an $SiO_2$ layer) for example. If both of the insulating layer 12 and the passivated polysilicon layer 13b are composed of $SiO_2$, the polysilicon layer 13a is surrounded by a homogeneous insulating matrix layer 12a (see Fig. 1(d)).

The entire surfaces of the insulating matrix layer 12a and polysilicon layer 13a are coated with an antimonysilicate glass (Sb-SG) layer 15, for example, as shown in Fig. 1(d). The Sb-SG layer 15 plays a role as a source of the impurity to be implanted in the layer 13a. The surface of the Sb-SG layer 15 is irradiated by an energy beam 16, a scanned Cw Ar laser beam, for example, having an energy density just enough to melt the polysilicon layer 13a. Since the Sb-SG layer 15 is transparent to the laser beam 16, the polysilicon layer 13a is heated up and then recrystallized into a single crystalline layer (19). In this heating, the single crystalline layer (19) is provided with n-type conduction capability, due to the diffusion of antimony atoms from the Sb-SG layer 15. Thus, a single crystalline layer of silicon, which is like an island embedded in an insulating matrix layer 12a, is formed. A plurality of such islands of single crystalline layers 19 are formed to be disposed in rows and columns on the substrate 1, in general.

The substrate 1 bearing single crystalline island 19 is subject to an epitaxial growth process using a low temperature CVD at 1000°C, for example. Thus, an epitaxial (single crystalline) silicon layer 18 is formed on the single crystalline island 19, while a polysilicon layer 17 is formed on the insulating matrix layer 12a, as shown in Fig. 1(e). The thickness of the layers 17 and 18 may be in the range from 2 to 10 micrometers, and is about 8 micrometers, for example.

Following the above epitaxial growth process, the substrate 1 bearing the polysilicon layer 17 and epitaxial layer 18 is further subject to the process for tentatively exposing side surface(s) of the epitaxial layer 18. The process is carried out according to the steps described below.

The upper surface of the epitaxial layer 18 is selectively masked by a layer 20, as shown in Fig. 1(f). The masking layer 20, of $Si_3N_4$ for example, is formed by using conventional thin film technology and patterned by using conventional photolithographic techniques. Then, the polysilicon layer 17 around the epitaxial layer 18 protected by the masking layer 20 is selectively removed by using a chemical reagent, as shown in Fig. 1(g). Thus, the side surface(s) of the epitaxial layer 18 are exposed. (If the epitaxial layer 18 has a round shape, the exposed side surface is cylindrical, and if the epitaxial layer 18 has a rectangular shape, it has multiple facets or multiple side surfaces).

A process for forming a conduction path at the or a side surface(s) is subsequently performed by introducing a single conductivity type impurity into the surface(s). In this process, the masking layer 20 protects the upper surface of the epitaxial layer 18 from being doped with the impurity. An exemplary method for the process is diffusion of an impurity gas at low temperature. An impurity source gas such as phosphorus tribromide (PBr$_4$) or phosphorus oxytrichloride (POCl$_4$) is generated by passing a carrier gas such as nitrogen into a solution of the impurity source gas, the solution being heated at about 40°C, and is introduced into a reaction chamber. In the reaction chamber the substrate bearing the epitaxial layer whose side surface(s) is exposed is heated at a temperature of about 900 to 950°C in an atmosphere of the impurity source gas. By contact with the exposed side surface(s) of the epitaxial layer, the impurity source gas is decomposed to liberate phosphorus molecules, and phosphorus atoms from the molecules diffuse into the side surface(s). Thus, an n-type conduction path 21 having a thickness of about 0.5 to 1 micrometer is formed at the side surface(s) of the epitaxial layer 18, as shown in Fig. 1(h).

Following the above process, a polycrystalline layer 22, a polysilicon layer, for example, having thickness of about 8 micrometers or more is deposited on the entire surface of the substrate 1 bearing the epitaxial layer 18, as shown in Fig. 1(i). For forming the polysilicon layer 22, a conventional method such as low temperature CVD at 650°C, for example, is used. Then, the polycrystalline layer 22, formed from polysilicon, for example, is entirely passivated, as shown in Fig. 1(j), by using an appropriate technique such as thermal oxidation at 900°C, for example. In the above process, it is not requisite to remove the masking layer 20 prior to the forming of the polycrystalline layer 22.

It is of course a possibility that the step as shown in Fig. 1(i) can be omitted if an insulating layer such as SiO$_2$ is deposited directly on the surface of the substrate 1 by means of a conventional CVD, for example, instead of the polycrystalline layer 22. Such a CVD process for forming a SiO$_2$ layer can be performed at a temperature in the range from 650 to 800°C.

The surface of the passivated polycrystalline layer 22 is, then, leveled down, by a mechanical polishing technique, for example, until the upper surface of the epitaxial layer 18 is just exposed, as shown in Fig. 1(k). Thus, a conduction path formed from the n-type impurity diffusion layer 21 at the side surface(s) of the epitaxial layer 18 is also exposed and prepared to be used as a connection to the original single crystalline island layer 19.

In a case in which the insulating matrix layer 12a (see from Fig. 1(d) to Fig. 1(i)) and the passivated polycrystalline layer 22 are composed of the same material, the single crystalline layer comprising the single crystalline island layer 19 and the epitaxial layer 18 are embedded in a homogeneous insulating matrix 12b.

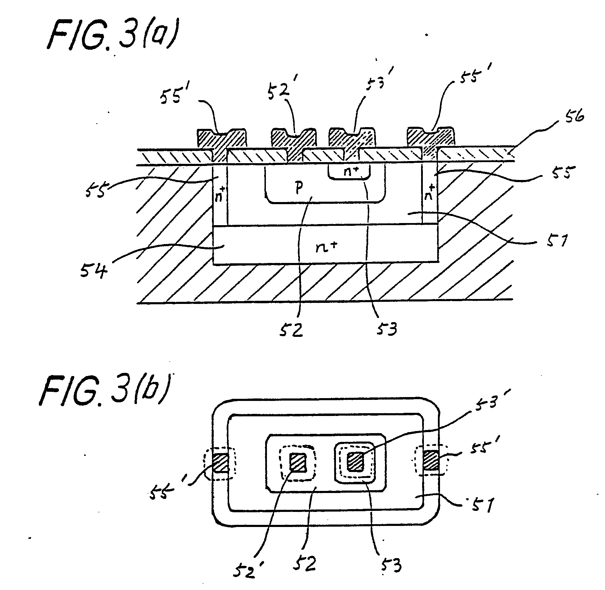

Subsequent to the above processes, a functional device such as transistor is formed, as shown in Figs. 3(a) and 3(b), which are respectively a partial schematic cross-sectional view and a plan view of an SOI semiconductor device. Referring to Figs. 3(a) and 3(b), a transistor comprising a collector region 51, a base region 52 and an emitter region 53 is formed in the epitaxial layer 18, and the orignal single crystalline island 19, which is highly doped with antimony as an n-type impurity, constitutes an n$^+$ buried layer 54 and the impurity diffusion layer 21 constitutes a connection 55 to the buried layer 54. The n-type collector region 51 is formed by voluntary diffusion of n-type impurity from the n$^+$ buried layer 54, whilst the p-type base region 52 and the n$^+$ emitter region 53 are formed by diffusing or ion implanting relevant impurities as in the fabrication of ordinary bipolar transistors. These regions and connection 55 are provided with terminal contacts 52', 53', and 55', each composed of a metallic alumiunium layer, for example. In Fig. 3(a), reference 56 denotes a surface-covering insulating film.

The above-described embodiment of the present invention enjoys the advantage of a kind of self-alignment provided by using the masking layer 20 during both processes for forming the tentative exposed side surface(s) of the epitaxial layer 18 and for forming the conduction path 21 at the side surface(s).

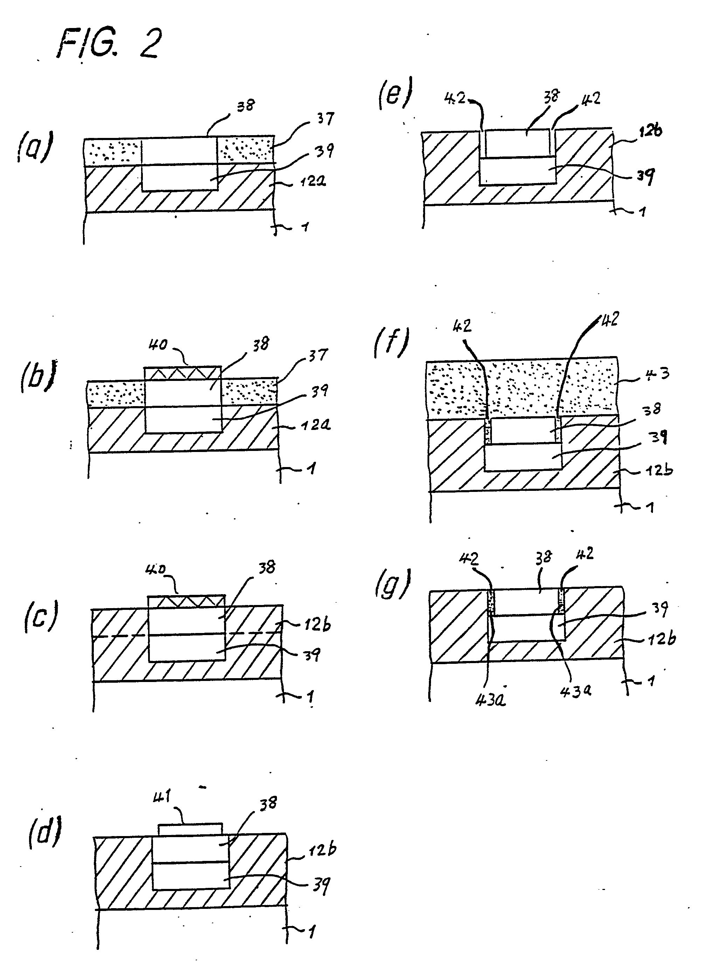

Figs. 2(a) to 2(g) are schematic cross-sectional views illustrating another embodiment of the present invention. In this embodiment, tentative exposed side surface(s) of an epitaxial layer are formed by providing a groove at the periphery of the epitaxial layer.

Referring to Fig. 2(a), an epitaxial layer 38 is grown on a single crystalline island 39, while a polycrystalline layer 37, which is grown together with the epitaxial layer 38, is formed on the insulating layer 12a supported by the substrate 1. The method for obtaining the above structure, and its dimensions, are quite the same as that described in connection with the embodiment of Fig. 1.

The surface of the epitaxial layer 38 is selectively masked by a layer 40 which is resistant to the treatment involved in the subsequent passivation step, as shown in Fig. 2(b), and then the exposed polycrystalline layer 37 is passivated by using a conventional thermal oxidation technique at 900°C, for example, as shown in Fig. 2(c). Thus, the single crystalline layer comprising the single crystalline island 39 and epitaxial layer 38 is embedded in a homogeneous insulating matrix layer 12b, if the passivated polycrystalline layer 37 results in the same material as that of the insulating layer 12a. The masking layer 40 is removed prior to the following grooving step.

If the polycrystalline layer 37 is converted into

$SiO_2$, $Si_3N_4$ is suitable for the masking layer 40, because the $Si_3N_4$ masking layer 40 can be patterned without affecting the polysilicon layer 37 before the passivation and can be preferentially removed without using any protective masking for the passivated polysilicon layer.

The surface of the epitaxial layer 38 is masked again by a photo-resist layer 41, for example, so that a peripheral area thereof, of a width of about 1.5 to 2 micrometers, is left unmasked, as shown in Fig. 2(d). Then, a groove 42, which has the depth reaching the underlying single crystalline island layer 39, is formed at the unmasked peripheral area, as shown in Fig. 2(e), by using a conventional chemical etching technique. The etching may be carried out until the total thicknesses of the epitaxial layer 38 and the original single crystalline island layer 39 at the peripheral area is etched through, thereby process control for the etching can be facilitated.

Following the above process for forming the tentative exposed side surface(s) of the epitaxial layer 38, a polycrystalline layer 43, a polysilicon layer, for example, is deposited on the entire surface of the substrate 1 bearing the epitaxial layer 38, as shown in Fig. 2(f), by using a low temperature technique, conventional low temperature CVD at 650°C, for example. The polysilicon layer 43 is formed to have the thickness larger than the depth of the groove 42, and is doped with an impurity providing n-type conduction, as in the single crystalline island layer 39. Thus, that part of the polycrystalline layer 43 filling the groove 42 constitutes a conduction path to the single crystalline island layer 39 underlying the epitaxial layer 38.

The polycrystalline layer 43 is, then, leveled down by a mechanical polishing technique, for example, until the upper surface of the epitaxial layer 39 is exposed, and thus, a conduction path 43a is provided to be used as a connection to the single crystalline island layer 39, as shown in Fig. 2(g).

Subsequent to the above processes, a functional device such as transistor is formed as already explained in the description of the previous embodiment with reference to Figs. 3(a) and 3(b), wherein a transistor comprising a collector region 51, a base region 52 and an emitter region 53 is formed in the epitaxial layer 38, and the original single crystalline island layer 39 constitutes the $n^+$ buried layer 54 and the polycrystalline layer 43a constitutes the connection 55 to the buried layer 54.

By taking the structural advantage of the SOI type semiconductor device, embodiments of the present invention allow a connection to be obtained to the buried layer of a bipolar transistor, the connection having the features as follows;

1) fabricated without using a deep vertical diffusion into an epitaxial layer,

2) fabricated regardless of the thickness of the epitaxial layer,

3) fabricated by using processes at temperatures lower than 1000°C.

Therefore, embodiments of the present invention can be particularly useful in the fabrication of the bipolar ICs for some applications including operational amplifiers and so forth, where transistors having breakdown voltages of some tens to hundreds of volts are needed, which require epitaxial layers as thick as ten microns, for example, which would otherwise need a deep vertical diffusion at a temperature higher than 1200°C to form the connection to the buried layer thereunder.

It will be recognized that modifications and variations of the described embodiments may be effected. For example, in the above-described embodiments, a Sb-SG layer is used for the source of the impurities which are doped into the single crystalline island, however, an ion-implantation technique can be used for the impurity doping to the single crystalline island layer which has been recrystallised by using laser beam without the coating of the Sb-SG layer, instead.

**Claims**

1. A method for fabricating an SOI (Semiconductor on Insulator) type semiconductor device, comprising:
   forming a single crystalline island on an insulating layer formed on a substrate, said single crystalline island having one conductivity type;
   forming an epitaxial layer on said single crystalline island;
   forming a tentative exposed side surface of said epitaxial layer;
   forming a conduction path at said exposed side surface, said conduction path extending from the upper surface of said epitaxial layer to said single crystalline island thereunder.

2. A method as claimed in claim 1, wherein said substrate is a silicon substrate.

3. A method as claimed in claim 1 or 2, wherein said insulating layer is composed of silicon dioxide.

4. A method as claimed in claim 2, wherein said insulating layer is formed by oxidation of said silicon substrate.

5. A method as claimed in any preceding claim, wherein said single crystalline island is formed by:
   forming a first polycrystalline layer on said insulating layer;
   selectively passivating said first polycrystalline layer except for the portion thereof corresponding to a region in which said single crystalline island is to be formed;
   coating the surface of said first polycrystalline layer, after said selective passivation, with a layer which is a source of dopant, for providing said first polycrystalline layer at the said portion with the said one conductivity type;
   heating for recrystallizing said first polycrystalline layer at the said portion and incidentally for diffusing said dopant into said first polycrystalline layer at the said portion; and
   removing said coating layer after said heating.

6. A method as claimed in claim 5, wherein said heating step is performed by irradiation with an energy beam.

7. A method as claimed in claim 6, wherein said energy beam is a laser beam.

8. A method as claimed in any one of claims 5 to 7, wherein said first polycrystalline layer is formed from a material which can result in the same substance as said insulating layer when passivated.

9. A method as claimed in any one of claims 5 to 8, wherein said first polycrystalline layer is a polysilicon layer.

10. A method as claimed in any one of claims 5 to 9, wherein said selective passivation is performed by oxidation.

11. A method as claimed in any one of claims 5 to 10, wherein said coating layer is formed from antimony-silicate glass (Sb-SG).

12. A method as claimed in any one of claims 5 to 11, wherein the epitaxial layer is formed from the same material as said first polycrystalline layer.

13. A method as claimed in any preceding claim wherein said epitaxial layer is composed of silicon.

14. A method as claimed in any preceding claim, wherein said tentative exposed side surface of said epitaxial layer is formed by:

forming a mask layer on the surface of said epitaxial layer; and

removing a second polycrystalline layer which has been formed around said epitaxial layer during formation of said epitaxial layer.

15. A method as claimed in claim 14, wherein the formation of said conduction path at said exposed side surface of said epitaxial layer is performed by introducing impurity of the said one conductivity type into said exposed side surface of said epitaxial layer (for example using a mask layer to prevent such introduction into an exposed upper surface of said epitaxial layer).

16. A method as claimed in claim 14 or 15, wherein the formation of said conduction path is followed by:

forming a third polycrystalline layer on the surface of said substrate bearing said epitaxial layer;

passivating said third polycrystalline layer; and

exposing the upper surface of said epitaxial layer after said passivation of said third polycrystalline layer.

17. A method as claimed in claim 16, wherein said third polycrystalline layer is formed from the same material as that forming said single crystalline island.

18. A method as claimed in claim 16 or 17, wherein said third polycrystalline layer is a polysilicon layer.

19. A method as claimed in claim 16, 17 or 18, wherein said passivation of said third polysilicon layer is performed by oxidation.

20. A method as claimed in claim 16, 17, 18, or 19, wherein said exposing of the upper surface of said epitaxial layer after said passivation of said third polycrystalline layer is performed by using a mechanical polishing.

21. A method as claimed in claim 16, 17, 18, 19 or 20 wherein said exposing of the upper surface of said epitaxial layer after said passivation of said third polycrystalline layer is performed so that the surface of said epitaxial layer is leveled to the surface of the passivated third polycrystalline layer around said epitaxial layer.

22. A method as claimed in any one of claims 1 to 13, wherein the said tentative exposed side surface of said epitaxial layer is formed by:

forming a first mask layer on the surface of said epitaxial layer by a first resist layer;

passivating a second polycrystalline layer which has been formed around said epitaxial layer during said process for forming said epitaxial layer;

removing said first mask layer;

selectively forming a second mask layer on the surface of said epitaxial layer so that a peripheral area of said surface of said epitaxial layer is exposed; and

forming a groove in said epitaxial layer, below said peripheral area, said groove having depth equal to or greater than the thickness of said epitaxial layer.

23. A method as claimed in claim 22, wherein the formation of said conduction path at said tentative exposed side surface of said epitaxial layer is performed by forming a further polycrystalline layer on the surface of said substrate bearing said epitaxial layer so that said groove formed in said epitaxial layer is filled with said further polycrystalline layer, said further polycrystalline layer including impurity of the said one conductivity type.

24. A method as claimed in claim 23, wherein said further polycrystalline layer is formed from the same material as that forming said single crystalline island.

25. A method as claimed in claim 23 or 24, wherein said further polycrystalline layer is a polysilicon layer.

26. A method as claimed in claim 22, 23, 24 or 25, wherein the formation of said conduction path is followed by exposing the upper surface of said epitaxial layer.

27. A method as claimed in claim 26, wherein the exposing of the upper surface of said epitaxial layer is performed by using a mechanical polishing.

28. A method as claimed in claim 26 or 27, wherein the exposing of the upper surface of said epitaxial layer is performed so that the upper surface of the said expitaxial layer is levelled to the surface of the passivated second polycrystalline layer around said epitaxial layer.

29. An SOI device formed with the use of a method as claimed in any preceding claim.

**Patentansprüche**

1. Verfahren zur Herstellung einer SOI-(Halbleiter auf Isolator)-Typ-Halbleitervorrichtung mit:

Bilden einer einkristallinen Insel auf einer isolierenden Schicht, die auf einem Substrat gebildet ist, welche genannte einkristalline Insel einen Leitfähigkeitstyp hat;

Bilden einer epitaktischen Schicht auf der genannten einkristallinen Insel;

Bilden einer versuchsweise exponierten Seitenoberfläche der genannten epitaktischen Schicht;

Bilden eines Leitungsweges an der genannten exponierten Seitenoberfläche, welcher genannte Leitungsweg sich von der oberen Oberfläche der genannten epitaktischen Schicht zu der genannten einkristallinen Insel darunter erstreckt.

2. Verfahren nach Anspruch 1, bei dem das genannte Substrat ein Siliciumsubstrat ist.

3. Verfahren nach Anspruch 1 oder 2, bei dem die genannte isolierende Schicht aus Siliciumdioxid besteht.

4. Verfahren nach Anspruch 2, bei dem die genannte isolierende Schicht durch Oxidation des genannten Siliciumsubstrats gebildet ist.

5. Verfahren nach einem der vorhergehenden Ansprüche, bei dem die genannte einkristalline Insel gebildet wird durch:

Bilden einer ersten polykristallinen Schicht auf der genannten isolierenden Schicht;

selektives passivieren der genannten ersten polykristallinen Schicht mit Ausnahme des Teils von ihr, welcher einem Bereich entspricht, in dem die genannte einkristalline Insel zu bilden ist;

Überziehen der Oberfläche der genannten ersten polykristallinen Schicht, nach der genannten selektiven Passivierung, mit einer Schicht, die eine Dotierungsquelle ist, um die genannte erste polykristalline Schicht an dem genannten Abschnitt mit dem genannten einen Leitfähigkeitstyp vorzusehen;

Erhitzen zum Rekristallisieren der genannten ersten polykristallinen Schicht an dem genannten Abschnitt und nebenbei zum Diffundieren des genannten Dotierungsmittels in die genannte erste polykristalline Schicht bei dem genannten Abschnitt; und

Entfernen der genannten Überzugsschicht nach dem genannten Erhitzen.

6. Verfahren nach Anspruch 5, bei dem der genannte Heizungsschritt durch Bestrahlung mit einem Energiestrahl ausgeführt wird.

7. Verfahren nach Anspruch 6, bei dem der genannte Energiestrahl ein Laserstrahl ist.

8. Verfahren nach einem der Ansprüche 5 bis 7, bei dem die genannte erste polykristalline Schicht aus einem Material gebildet ist, welches zu derselben Substanz führen kann, wie die genannte isolierende Schicht, wenn sie passiviert ist.

9. Verfahren nach einem der Ansprüche 5 bis 8, bei dem die genannte erste polykristalline Schicht eine Polysiliciumschicht ist.

10. Verfahren nach einem der Ansprüche 5 bis 9, bei dem die genannte selektive Passivierung durch Oxidation durchgeführt wird.

11. Verfahren nach einem der Ansprüche 5 bis 10, bei dem die genannte Überzugsschicht aus Antimonsilikatglas (Sb-SG) gebildet wird.

12. Verfahren nach einem der Ansprüche 5 bis 11, bei dem die epitaktische Schicht aus demselben Material wie die genannte erste polykristalline Schicht gebildet wird.

13. Verfahren nach einem der vorhergehenden Ansprüche, bei dem die genannte epitaktische Schicht aus Silicium besteht.

14. Verfahren nach einem der vorhergehenden Ansprüche, bei dem die genannte versuchsweise exponierte Seitenoberfläche der genannten epitaktischen Schicht gebildet wird durch:

Bilden einer Maskenschicht auf der Oberfläche der genannten epitaktischen Schicht; und

Entfernen einer zweiten polykristallinen Schicht, welche während der Bildung der genannten epitaktischen Schicht um die genannte epitaktische Schicht herum gebildet worden ist.

15. Verfahren nach Anspruch 14, bei dem die Bildung des genannten Leitungsweges an der exponierten Seitenoberfläche der genannten epitaktischen Schicht durch Einführung von Verunreinigungen von dem genannten einen Leitfähigkeitstyp in die genannte exponierte Seitenoberfläche der genannten epitaktischen Schicht gebildet wird (z.B. unter Verwendung einer Maskenschicht zur Verhinderung solch einer Einführung in eine exponierte obere Oberfläche der genannten epitaktischen Schicht).

16. Verfahren nach Anspruch 14 oder 15, bei auf das Bilden des genannten Leitungsweges folgt:

Bilden einer dritten polykristallinen Schicht auf der genannten Oberfläche des genannten Substrats, welches die genannte epitaktische Schicht trägt;

Passivieren der dritten polykristallinen Schicht; und

Exponieren der oberen Oberfläche der genannten epitaktischen Schicht nach der genannten Passivierung der genannten dritten polykristallinen Schicht.

17. Verfahren nach Anspruch 16, bei dem die genannte dritte polykristalline Schicht aus demselben Material gebildet ist, wie dasjenige, welches die genannte einkristalline Insel bildet.

18. Verfahren nach Anspruch 16 oder 17, bei dem die genannte dritte polykristalline Schicht eine Polysiliciumschicht ist.

19. Verfahren nach Anspruch 16, 17, oder 18, bei dem die genannte Passivierung der genannten dritten Polysiliciumschicht durch Oxidation ausgeführt wird.

20. Verfahren nach Anspruch 16, 17, 18 oder 19, bei dem das genannte Exponieren der oberen Oberfläche der genannten epitaktischen Schicht nach der genannten Passivierung der genannten dritten polykristallinen Schicht durch Verwendung eines mechanischen Polierens durchgeführt wird.

21. Verfahren nach Anspruch 16, 17, 18, 19 oder 20, bei dem die genannte Exponierung der oberen Oberfläche der genannten epitaktischen Schicht nach der genannten Passivierung der genannten dritten polykristallinen Schicht so durchgeführt wird, daß die Oberfläche der genannten epitaktischen Schicht auf den Pegel der Oberfläche der passivierten dritten polykristallinen Schicht um die genannte epitaktische Schicht herum gebracht wird.

22. Verfahren nach einem der Ansprüche 1 bis 13, bei dem die genannte versuchsweise exponierte Seitenoberfläche der genannten epitaktischen Schicht gebildet wird durch:

Bilden einer ersten Maskenschicht auf der Oberfläche der genannten epitaktischen Schicht durch eine erste Resistschicht;

Passivieren einer zweiten polykristallinen Schicht, welche während des Verfahrens der Bildung der genannten epitaktischen Schicht um die genannte epitaktische Schicht herum gebildet worden ist;

Entfernen der genannten ersten Maskenschicht;

selektives Bilden einer zweiten Maskenschicht auf der Oberfläche der genannten epitaktischen Schicht, so daß ein peripherer Bereich der genannten Oberfläche der genannten epitaktischen Schicht exponiert wird; und

Bilden einer Nut in der genannten epitaktischen Schicht, unterhalb des genannten peripheren Bereichs, welche genannte Nut eine Tiefe hat, die gleich oder größer als die Dicke der genannten epitaktischen Schicht ist.

23. Verfahren nach Anspruch 22, bei dem die Bildung des genannten Leitungsweges bei der genannten versuchsweise exponierten Seitenoberfläche der genannten epitaktischen Schicht durch Bilden einer weiteren polykristallinen Schicht auf der Oberfläche des genannten Substrats gebildet wird, welches die genannte epitaktische Schicht trägt, so daß die genannte Nut, die in der genannten epitaktischen Schicht gebildet wird, mit der genannten weiteren polykristallinen Schicht gefüllt wird, welche genannte weitere polykristalline Schicht Verunreinigungen von dem genannten einen Leitfähigkeitstyp enthält.

24. Verfahren nach Anspruch 23, bei dem die genannte weitere polykristalline Schicht aus demselben Material gebildet ist, wie das, welches die genannte einkristalline Insel bildet.

25. Verfahren nach Anspruch 23 oder 24, bei dem die genannte weitere polykristalline Schicht eine Polysiliciumschicht ist.

26. Verfahren nach Anspruch 22, 23, 24 oder 25, bei dem auf die Bildung des genannten Leitungsweges das Exponieren der oberen Oberfläche der genannten epitaktischen Schicht folgt.

27. Verfahren nach Anspruch 26, bei dem das Exponieren der oberen Oberfläche der genannten epitaktischen Schicht unter Verwendung eines mechanischen Polierens ausgeführt wird.

28. Verfahren nach Anspruch 26 oder 27, bei dem das Exponieren der oberen Oberfläche der genannten epitaktischen Schicht so durchgeführt wird, daß die obere Oberfläche der genannten epitaktischen Schicht auf die Oberfläche der passivierten zweiten polykristallinen Schicht um die genannte epitaktische Schicht herabgepegelt wird.

29. Eine SOI-Vorrichtung, hergestellt unter Verwendung eines Verfahrens nach einem der vorhergehenden Ansprüche.

**Revendications**

1. Un procédé de fabrication d'un dispositif semi-conducteur du type SOI (semi-conducteur sur isolant) comprenant:

la formation d'un îlot monocristallin sur une couche isolante formée sur un substrat, ledit îlot monocristallin ayant un type de conductivité;

la formation d'une couche épitaxiale sur ledit îlot monocristallin;

la formation d'une surface latérale exposée provisoire de ladite couche épitaxiale;

la formation d'un trajet de conduction au niveau de ladite surface latérale exposée, ce trajet de conduction s'étendant depuis la surface supérieure de ladite couche épitaxiale audit îlot monocristallin se trouvant en dessous.

2. Un procédé selon la revendication 1, selon lequel ledit substrat est un substrat de silicium.

3. Un procédé selon la revendication 1 ou 2, selon lequel ladite couche isolante est composée de dioxyde de silicium.

4. Un procédé selon la revendication 2, selon lequel ladite couche isolante est formée par oxydation dudit substrat de silicium.

5. Un procédé selon l'une quelconque des revendications précédentes, selon lequel ledit îlot monocristallin est formé par:

formation d'une première couche polycristalline sur ladite couche isolante;

passivation sélective de ladite première couche polycristalline à l'exception d'une portion de celle-ci correspondant à une région dans laquelle ledit îlot monocristallin doit être formé;

revêtement de la surface de ladite première couche polycristalline, après ladite passivation sélective, avec une couche qui est une source de dopant, pour fournir à ladite première couche polycristalline dans ladite portion ledit premier type de conductivité;

chauffage pour la recristallisation de ladite première couche polycristalline dans ladite portion et incidemment pour diffuser ledit dopant dans ladite première couche polycristalline à ladite portion; et

élimination de cette couche de revêtement après ledit chauffage.

6. Un procédé selon la revendication 5, selon lequel ladite étape de chauffage est conduite par irradiation au moyen d'un faisceau d'énergie.

7. Un procédé selon la revendication 6, selon lequel ledit faisceau d'énergie est un faisceau laser.

8. Un procédé selon l'une quelconque des revendications 5 à 7, selon lequel ladite première couche polycristalline est formée à partir d'un matériau qui peut conduire à la même substance que ladite couche isolante lorsqu'elle a été passivée.

9. Un procédé selon l'une quelconque des revendications 5 à 8, selon lequel ladite première couche polycristalline est une couche de polysilicium.

10. Un procédé selon l'une quelconque des revendications 5 à 9, selon lequel ladite passivation sélective est conduite par oxydation.

11. Un procédé selon l'une quelconque des revendications 5 à 10, selon lequel ladite couche de revêtement est formée à partir du verre de silicate d'antimoine (Sb-SG).

12. Un procédé selon l'une quelconque des revendications 5 à 11, selon lequel la couche épitaxiale est formée à partir du même matériau que ladite première couche polycristalline.

13. Un procédé selon l'une quelconque des revendications précédentes, selon lequel ladite couche épitaxiale est composée de silicium.

14. Un procédé selon l'une quelconque des revendications précédentes, selon lequel ladite surface latérale exposée provisoire de ladite couche épitaxiale est formée par:

formation d'une couche de masque sur la surface de ladite couche épitaxiale; et

élimination d'une seconde couche polycristalline qui a été formée autour de ladite couche épitaxiale durant la formation de ladite couche épitaxiale.

15. Un procédé selon la revendication 14, selon lequel la formation dudit trajet de conduction au niveau de ladite surface latérale exposée de ladite couche épitaxiale est conduite par introduction d'impuretés dudit type de conductivité dans ladite surface latérale exposée de ladite couche épitaxiale (par exemple en utilisant une couche de masquage pour empêcher une telle introduction dans une surface supérieure exposée de ladite couche épitaxiale).

16. Un procédé selon la revendication 14 ou 15, selon lequel la formation dudit trajet de conduction est suivie de:

la formation d'une troisième couche polycristalline sur la surface dudit substrat portant ladite couche épitaxiale;

la passivation de ladite troisième couche polycristalline; et

l'exposition de la surface supérieure de ladite couche épitaxiale après ladite passivation de ladite troisième couche polycristalline.

17. Un procédé selon la revendication 16, selon lequel ladite troisième couche polycristalline est formée à partir du même matériau que celui formant ledit îlot monocristallin.

18. Un procédé selon la revendication 16 ou 17, selon lequel ladite troisième couche polycristalline est une couche de polysilicium.

19. Un procédé selon la revendication 16, 17 ou 18, selon lequel ladite passivation de ladite troisième couche de polysilicium est conduite par oxydation.

20. Un procédé selon la revendication 16, 17, 18 ou 19, selon lequel ladite exposition de la surface supérieure de ladite couche épitaxiale après ladite passivation de ladite troisième couche polycristalline est effectuée en utilisant un polissage mécanique.

21. Un procédé selon la revendication 16, 17, 18, 19 ou 20, selon lequel ladite exposition de la surface supérieure de ladite couche épitaxiale après ladite passivation de ladite troisième couche polycristalline est conduite de façon que la surface de ladite couche épitaxiale soit nivelée à la surface de la troisième couche polycristalline passivée autour de ladite couche épitaxiale.

22. Un procédé selon l'une quelconque des revendications 1 à 13, selon lequel ladite surface latérale exposée provisoire de ladite couche épitaxiale est formée par:

formation d'une première couche de masque sur la surface de ladite couche épitaxiale au moyen d'une première couche de photorésist;

passivation d'une seconde couche polycristalline qui a été formée autour de ladite couche épitaxiale durant ledit procédé pour former ladite couche épitaxiale;

élimination de ladite première couche de masque;

formation sélective d'une seconde couche de masque sur la surface de ladite couche épitaxiale de façon qu'une zone périphérique de ladite surface de ladite couche épitaxiale soit exposée; et

formation d'une rainure dans ladite couche épitaxiale, sous ladite zone périphérique, cette rainure ayant une profondeur égale ou supérieure à l'épaisseur de ladite couche épitaxiale.

23. Un procédé selon la revendication 22, selon lequel la formation dudit trajet de conduction au niveau de ladite surface latérale exposée provisoire de ladite couche épitaxiale est réalisée par formation d'une autre couche polycristalline sur la surface dudit substrat portant ladite couche épitaxiale, de façon que ladite rainure formée dans ladite couche épitaxiale soit remplie par ladite autre couche polycristalline, ladite autre couche polycristalline incluant une impureté dudit type de conductivité.

24. Un procédé selon la revendication 23, selon lequel ladite autre couche polycristalline est formée à partir du même matériau que celui formant ledit îlot monocristallin.

25. Un procédé selon la revendication 23 ou 24, selon lequel ladite autre couche polycristalline est une couche de polysilicium.

26. Un procédé selon la revendication 22, 23, 24 ou 25, selon lequel la formation dudit trajet de conduction est suivie par l'exposition de la surface supérieure de ladite couche épitaxiale.

27. Un procédé selon la revendication 26, selon lequel l'exposition de la surface supérieure de ladite couche épitaxiale est réalisée en utilisant un polissage mécanique.

28. Un procédé selon la revendication 26 ou 27, selon lequel l'exposition de la surface supérieure de ladite couche épitaxiale est réalisée de façon que la surface supérieure de ladite couche épitaxiale soit nivelée à la surface de la seconde couche polycristalline passivée autour de ladite couche épitaxiale.

29. Un dispositif SOI formé en utilisant un procédé défini dans l'une quelconque des revendications précédentes.

# FIG. 1

(a) ... 13, 12, 1

(b) ... 14, 13, 12, 1

(c) ... 13a, 13b, 12, 1

(d) ... 16, 15, 13a (19), 12a, 1

(e) ... 19, 18, 17, 12a, 1

(f) ... 19, 20, 18, 17, 12a

(g) ... 20, 18, 19, 12a, 1

(h) ... 20, 18, 21, 21, 19, 12a, 1

(i) ... 20, 22, 18, 21, 19, 12a, 1

(j) ... 20, 18, 21, 12b, 19, 1

(k) ... 21, 18, 21, 12b, 19, 1

1

# FIG. 2

(a) 38, 37, 39, 12a, 1

(b) 40, 38, 37, 39, 12a, 1

(c) 40, 38, 12b, 39, 1

(d) 41, 38, 12b, 39, 1

(e) 42, 38, 42, 12b, 39, 1

(f) 42, 42, 43, 38, 39, 12b, 1

(g) 42, 38, 42, 39, 12b, 43a, 43a, 1

## FIG. 3(a)

## FIG. 3(b)